# EUROPEAN PATENT APPLICATION

(11) **EP 1 463 063 A1**
(43) Date of publication of application: **29.09.2004**
(21) Application number: 04251764.9
(22) Date of filing: 26.03.2004
(51) Int. Cl.: G11C 29/00

(54) **Signature cell**

(30) Priority: 28.03.2003 US 402536
(71) Applicant: STMicroelectronics, Inc., Carrollton Texas 75006-5039 (US)
(72) Inventor: Soundron, Agnel, Longmount, Colorado 80503 (US)
(74) Representative: Style, Kelda Camilla Karen

(57) **Abstract**

A signature structure and method of use for verifying a programmed state of a memory circuit of an integrated circuit is disclosed. The integrated circuit comprises a memory cell, a built-in-self-test cell, a compare cell and a signature cell. The signature cell includes a set of first conductive paths in a first level of conductive material and a set of second conductive paths in a second level of conductive material. The first level of conductive material is separated from the second level of conductive material by an insulating material. A contact structure is placed in a manner such that a first conductive path is in electrical contact with a second conductive path. The selection of a placement of the contact structure is such the first and second conductive paths are electrically coupled to a voltage reference source. The combination of the coupled and uncoupled first and second conductive paths provide the bit states of a reference signature word. The built-in-self-test structure provides addressing data to the memory structure and generates a resulting signature word. The resulting signature word is compared to the reference signature word to generate a status condition of the programmed state of the memory structure. The status condition is used to indicate a pass or fail test result regarding the programmed state of the memory structure.

## Description

### BACKGROUND OF THE INVENTION

### Field of the Invention

The present invention is directed to an improvement in test circuits for read-only memories in integrated circuits. Specifically, the invention relates to a signature circuit of a read-only memory test circuit that stores an expectant signature word while increasing semiconductor area utilization and reducing manufacturing test time of integrated circuits.

### Description of the Related Art

In testing read-only memories (ROM) in integrated circuits, die size and test time at manufacture are two design requirements directly related to manufacturing cost of the integrated circuit product. Die size is the area of the semiconductor material incorporating the product design specification. For a given product design specification, die size is measured in terms of semiconductor area utilization. Semiconductor area utilization is defined as the ratio of area of a layer of material to the area of the die void of that layer of material. Given the product design specification, an increase in the semiconductor area utilization results in a smaller die size and a lower cost integrated circuit.

Test at the time of manufacture is the process of confirming that the actual programmed data of the ROM circuit as implemented on the semiconductor corresponds to the desired data. ROM testing requires significant test time per integrated circuit on expensive external test equipment. Accordingly, two of the goals in designing an integrated circuit are to increase semiconductor area utilization and to reduce test time at manufacture. However, the solutions for achieving these two goals tend to be in opposition to each other.

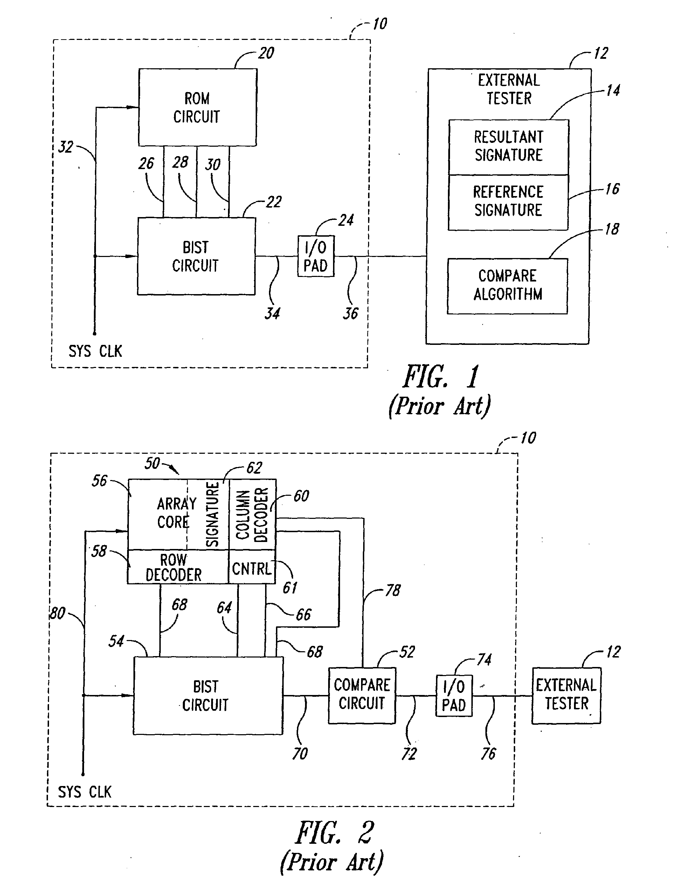

A typical integrated circuit may have a number of ROM circuits occupying a portion of the area of the die. Each of these ROM circuits must be verified by testing the actual programmed data contained within the core array of the ROM. The verification process is accomplished by generating a resultant signature word from the actual programmed data of the ROM. For example, a ROM test circuit is shown in Figure 1. The ROM test circuit 10 includes a built-in-self-test (BIST) circuit 22 coupled by control 30, address 26 and data 28 lines to the ROM 20. The BIST circuit 22 includes a means for collecting and processing the actual programmed data and for generating the resultant signature word. The resultant signature word is representative of the actual programming data contained in the ROM. If there were a fault with in the core array of the ROM that affected the actual programmed data of the ROM, then the resultant signature word would contain a representation of that fault. To detect the fault, external test equipment 12 stores an expectant signature word 16 that is representative of the expected programmed data of the ROM 20. The external test equipment 12 compares the resultant signature word 14 to the expectant signature word 16, and then generates a verification status. The verification status is an indication of whether the actual programmed data of the ROM 20 matches the expected programmed data. If the actual and expected programmed data do not match, then the integrated circuit part is rejected.

Accordingly, to accomplish the above ROM test, the resultant signature word 16 must be communicated to the external test equipment 12. This communication is accomplished by either shifting the resultant signature word 16 in serial through an I/O pad 24 or in parallel through a plurality of I/O pads 24. The result is a design trade-off problem between the serial method, which increases test time, and the parallel method which increases die size. The serial method requires a clock cycle for each bit to shift the expectant signature word to the external tester. The serial method can be come prohibitively time consuming if the integrated circuit contains multiple ROM circuits 20. The parallel method is faster; however, this method requires the number of I/O pads 24 to be equal to the number of bits in the expectant signature word. Even if the I/O pads are multiplex during test operations, test control logic and MUX logic must be added to the product design specification to control the I/O pads. The additional I/O pads, test control and MUX logic increase the die size of the integrated circuit and the cost of the product.

As one solution to the above design trade-off problem, ROM test circuits are built into the product design specification and constructed on the die for verifying the ROM circuits. These built-in test circuits improve manufacturing test time by allowing testing to occur at the clock frequency of the integrated circuit, which is generally faster than the clock frequency of the external test equipment. For example, a ROM test circuit includes a BIST circuit 54, a compare circuit 52 and a signature portion 62 of the ROM 50 as shown in Figure 2. Control lines 64, address lines 68 and data lines 66 are coupled from the BIST circuit 54 to the ROM 50. A clock line 80 provides a systems clock for timing of the ROM control. In addition, the column decoder 58, row decoder 60 and control circuit 61 must be of sufficient size for both the ROM array and cells 62 for the signature word storage. In this example, the expectant signature word is stored in a set of memory cells 62 within the core array 56 of the ROM circuit. Having both the expectant signature word and the compare circuit 52 within the integrated circuit improves the manufacturing test time. However, the same design trade-off problem exists. Specifically, manufacturing test time improvement is limited by the requirement of a read cycle to obtain the expectant signature word from the ROM 50, and the die size is increased as a result of the additional address decode logic 58, memory cells 62 and level shifters 60 structured within the ROM 50 and used for storing the expectant signature word. Consequently, the above ROM test circuits 10 still consume valuable semiconductor area and manufacturing test time thus increasing the cost of the integrated circuit.

Furthermore, in the case of the above example as shown in Figure 2 where the expectant signature word is stored in a portion 62 core array 56 of the ROM 50, the problem of die size is further exacerbated by the requirement of routing the results of the expectant signature word from the ROM 50 to the compare circuit 52 through a line 78 within the channel region of the integrated circuit. Generally, within the integrated circuit, the ROM circuit 50 is implemented as a fixed size macrocell, and the compare circuit 52 is implemented as a logical unit of standard cells. The line 78 for the expectant signature word consumes routing area within the channel region, which limits the routing area for critical path lines. This limitation on routing area is true for each memory in the integrated circuit; moreover, there is a cumulative effect on the routing area of the channel when multiple ROMs are implemented. The limitation on channel routing area results in increased die size to provide additional area to the channel region.

Consequently, the two design goals of reducing die size and reducing manufacturing test time are not met by the proposed solution of the ROM test circuits having signature circuit structured within the core array of the ROM circuits of an integrated circuit.

### BRIEF SUMMARY OF THE INVENTION

An embodiment of the present invention provides a semiconductor integrated circuit comprising a ROM test circuit having a signature circuit, a built-in-self-test (BIST) circuit, a compare circuit and an associated ROM. Specifically, an embodiment provides a signature circuit storing an expectant signature word having reduced semiconductor area and reduced manufacturing test time.

The ROM test circuit is structured such that the BIST circuit is coupled to the ROM to transmit address, control and data and to receive actual programmed data. The BIST circuit is coupled to a first input of the compare circuit to provide the resultant signature word. The expectant signature circuit is coupled to a second input of the compare circuit to provide the expectant signature word. The compare circuit is coupled to an I/O pad that can selectively be connected to external test equipment to provide a verification status of the actual programmed data of the ROM.

An embodiment of the built-in-self-test circuit comprises an associated ROM control circuit, address generation circuit, data storage and resultant signature generation circuit. The BIST circuit controls the associated ROM during testing by communicating control and address words, and receiving data words. The BIST circuit operates a signature analysis algorithm on the received data words to form a resultant signature word. The resultant signature word is communicated to the first input of the compare circuit. The resultant signature word is representative of the actual programmed data of the associated ROM. If there is a fault in the actual programmed data of the associated ROM as compared to the expected programmed data as represented by the expectant signature word, then the resultant signature word will contain a bit fault with respect to the expectant signature word.

### BRIEF DESCRIPTION OF THE SEVERAL VIEWS OF THE DRAWING(S)

Figure 1 is a block diagram ROM test structure and testing apparatus according to the prior art.

Figure 2 is a block diagram of a prior art ROM having a memory core with an integrated signature module and a built-in-self-test module with an external tester.

Figure 3 is a block diagram of one embodiment of the present invention having a memory core, a signature structure and built-in-self-test structure.

Figure 4 is an embodiment of the output buffers of the present invention for a signature module structured as a standard cell.

Figure 5 is one embodiment of the present invention of the physical layout of a signature cell within the standard cell portion of the chip.

Figure 6 is a block diagram and flowchart representation of the method for producing the invention.

### DETAILED DESCRIPTION OF THE INVENTION

To achieve the design goals of increased area utilization (small die size) and improved manufacturing test time, an embodiment of the present invention provides an improved test circuit for determining the validity of the actual programmed data of a read-only memory. Specifically, an embodiment of the present invention provides a signature circuit having a circuit and layout structure that improves manufacturing test time and area utilization of the integrated circuit product. The ROM test circuit of the present invention is manufactured using standard semiconductor processing techniques.

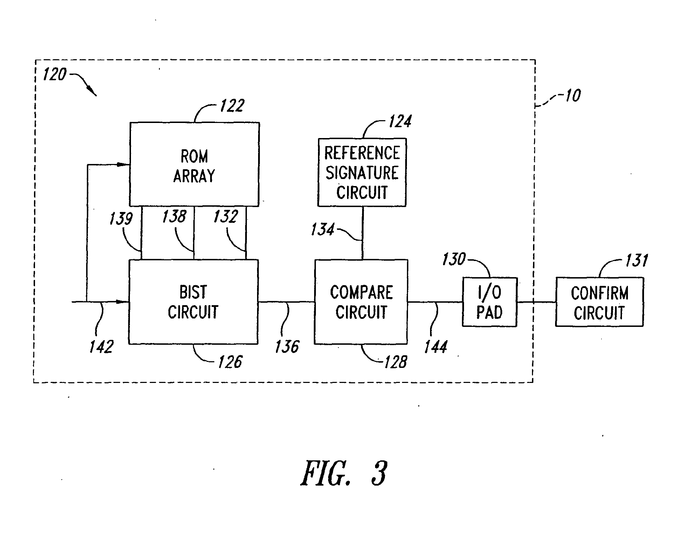

As shown in Figure 3, an embodiment of the invention with ROM 10 circuit comprises a structure having ROM array 122, a built-in-self-test (BIST) circuit 126, a compare circuit 128 and a reference signature circuit 124. The BIST circuit 126 is connected to the ROM array 122 by lines 132, 138 and 139 to transmit address and control signals as well as to receive data. A clock line 142 provides a clock signal to the ROM array 122 and the BIST circuit 126. The BIST circuit 126 is connected to the compare circuit 128 by lines 136 to provide a resultant signature word. The resultant signature word is representative of the actual programmed data present within the ROM core array 122. Reference signature circuit 124 is connected to the compare circuit 128 by line 134 to provide an expectant signature word. The expectant signature word is representative of the expected programmed data. The reference signature circuit is within another area of the chip, rather than being part of the ROM array. For example, it can be in the peripheral circuit area, the standard cell area, a macro cell area or some other part of the ROM chip 10. The compare circuit 128 compares the resultant and expectant signature words to provide a verification status signal. If desired, the verification status signal can be transmitted to an I/O pad 130 and to an external confirm circuit 131, though this is not required in all embodiments. The test results can be stored on chip for later probe or testing. The verification status provides an indication of whether the resultant signature word and the expectant signature word match. This will indicate whether the actual programmed data matches the expected programmed data of the associated ROM. If the resultant signature word contained a bit fault indicating that the actual programmed data of the ROM is incorrect with respect to the expected programmed data then the verification status would be set to negative.

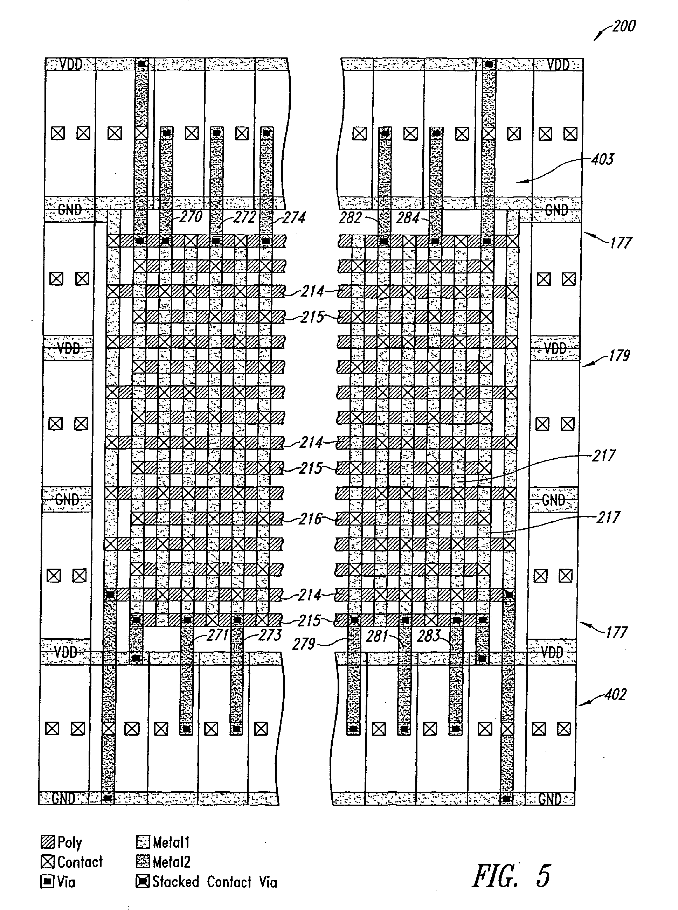

As shown in Figures 3 and 5, one embodiment of the signature circuit, in schematic representation as shown in Figure 5, comprises an output circuit 177 and a signature storage circuit 179. The signature storage circuit comprises a first set of conductive lines, a second set of conductive line and a set of interconnects. Each conductive line of the first and second set has first and second end-points. The first set of conductive lines are arranged in a pair such that a first conductive line of the pair is connected at opposite end-points to the first supply VDD and a second conductive line of the pair is connected at opposite end-points to the second supply GND. The second set of conductive lines comprises 16 lines, one for each bit of the expectant signature word. Each of the 16 conductive lines of the second set is connected at an end-point to an input pin of the output circuit. The storage circuit 129 is structured such that a selection of interconnects will provide a unique expectant signature word. For example, if the expectant signature word is determined by the BIST generator algorithm to be A6B4 Hex or 1010011010110100 binary, then the required selection of connectors of the interconnect circuit is as made to provide this as an output.

The output circuit receives the 16 conductive lines of the interconnect circuit. Each of the conductive lines is connected to an input pin of a non-inverting logic buffer of the output circuit. The output pin of each non-inverting logic buffer provides a bit value of the expectant signature word. In an alternative embodiment, inverting logic buffer may be used. Employing inverting logic buffers requires a corresponding inversion of the selection of interconnects of the interconnect circuit.

The storage circuit 179 contains the expectant signature programming information. The expectant signature programming information consists of a selection of interconnects 216 such that a unique expectant signature word is provided which is associated with unique programming data of the ROM. The output circuit 177 provides stable output logic levels for the expectant signature word.

Specifically, an embodiment of the interconnect circuit contains a first plurality of parallel conductive strips on a first conductive layer 214, an insulating layer, a plurality of interconnects 216 and a second plurality of parallel conductive strips 215 on a second conductive layer. The first plurality of parallel conductive strips are arranged in 8 pairs of strips such that the first strip of the pair is connected to a first supply VDD and the second strip of the pair is connected to a second supply GND. The first and second strips of the pair are spaced apart at the minimum design rule spacing for the first layer of conductive material. A layer of insulating material separates the first and second conductive layers. Each strip of the second plurality of parallel conductive strips is connected to a buffer circuit of the output circuit via connections 270-283. The third set of parallel conductive strips 217 are formed above and orthogonal to the first and second plurality of parallel conductive strips such that overlapping regions of the first and second conductive layers are formed. The first two conductors 214 and 215 are preferably polysilicon and the third is preferably a metal.

The plurality of interconnects 216 comprises a contact having a region of conductive material or a via-opening filled with the second conductive material. In either form contact or via-opening, an interconnect is formed such that the interconnect passes through the insulating layer and electrically connects the first and second conductive layers. A first set of interconnects are positioned at a subset of the overlapping regions thus forming conductive interconnects to the first supply VDD. A second set of interconnects are at the overlapping regions thus forming conductive interconnects to the second supply GND, as shown in Figure 5. First and second sets of interconnects are placed in a unique selection to define the logic state of the bits of the expectant signature word. Both the first and second set of interconnects of the storage circuit 179 are defined in the same masking layer. Moreover, the selection of interconnects of the interconnect circuit and the actual programmed data of the ROM are defined by the same process mask layer. Consequently, reprogramming the data of the associated ROM requires only a single mask for programming both the data of the ROM and the selection of the interconnect circuit.

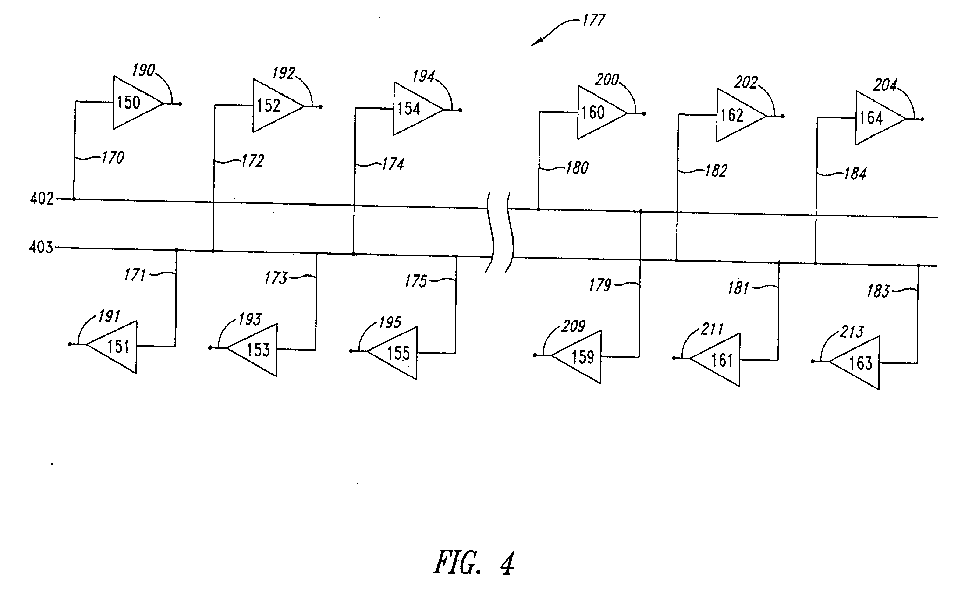

In one embodiment, as shown in Figure 4, an interconnect circuit is formed as part of the reference signature circuit 124. The output circuit is formed of 16 buffer cells with a first set of 8 buffer cells formed in a first row and a second set of 8 buffer cells formed in a second row. The first set of 8 buffer cells is formed on a first edge of the interconnect circuit and the second set of 8 buffer cells is formed on an opposite edge of the interconnect circuit. The output circuit is completed by a first set of 3 buffer cells positioned on an edge of the interconnect circuit and a second set of 3 buffer cells positioned on an opposite edge of the interconnect circuit. The best placement of the buffering cells is to be arranged such that the aspect ratio of the signature circuit is substantially near unity. The buffer circuits are structure to have both power (VDD) and ground (GND) straps that electrically connect when the buffer circuits are abutted. Accordingly, the signature circuit 124 is compatible with placement and abutment of other standard cell logic circuits in proximity to the signature circuit within a standard cell region.

In an embodiment, the interconnect circuit includes the first plurality of parallel conductive strips formed in a polysilicon layer, an insulating layer formed in a dielectric material, a plurality of interconnects formed as contacts having a region of metal and the second plurality of conductive strips formed in a metal layer. Here again, the orientation of the first plurality of polysilicon strips and the second plurality of first metal strips is orthogonal. The interconnects are positioned to electrically connect the strips of the polysilicon layer to the strips of the first metal layer at overlapping regions of the polysilicon and metal layers. A first subset of the contacts is formed to electrically interconnect a strip of the first metal to the first supply VDD through the polysilicon strip and contact. An end-point of the strip of first metal is terminated at an input pin of a buffer circuit of the output circuit. The output pin of the buffer circuit drives a bit of expectant signature word. With this signature circuit layout, an expectant signature word of bit width 16 is formed having a unique association to the actual programmed data of the associated ROM.

In an alternative embodiment, the first and second conductive layers are formed as first and second polysilicon layers electrically isolated by a dielectric layer and electrically connected at overlapping regions by a contact layer. In this embodiment, the actual programmed data of the ROM and the interconnect selection defining the expectant signature word are both formed by a single process mask, in this instance, by the contact mask.

In a further embodiment, the first and second conductive layers are formed as first and second metal layers electrically isolated by an insulating layer and electrically connected at overlapping regions by a via-opening layer. In this embodiment, the actual programmed data of the ROM and the interconnect selection defining the expectant signature word are both formed by a single process mask, in this instance, by the via-opening mask.

Any acceptable compare circuit can be used for compare circuit 128. Many such compare circuits 128 are known in the art and could be used, so the details are not shown in a schematic. For example, in one embodiment the compare circuit is composed of a first stage of exclusive-OR logic circuits, each XOR circuit receives a bit of the expectant and a bit of the resultant signature word. The first XOR cell can receive the least significant bits of the expectant signature word and the resultant signature word. Successive XOR cells are connected in a like manner until the final XOR receives the most significant bits of the expectant signature word and the resultant signature word. A second stage XOR cell receives the results of the first stage of XOR cells. The second stage XOR cell provides a verification status at an output pin. The output pin of the second stage XOR cell is connected to a first input pin of a multiplexer cell having a second input pin connected to the second supply (GND). Other compare schemes can be used as noted above.

The test control logic on the chip allows the ROM 10 to be placed in test mode. The output pin of the compare circuit 128 can be connected to an input pin of an I/O pad cell 130 if desired. The I/O pad cell 130 provides a connection to the external test equipment, such as confirm circuit 131. Thus, the compare circuit 128 structured in the above manner generates the verification status at combinational logic speed of an XOR circuit. The combinational logic speed of the compare circuit 128 is faster than the equivalent compare operation on standard external test equipment, which need not be used with the present invention.

A signature circuit of the structure presented in the above embodiments provides the advantage of increased area utilization and reduced die size. Specifically, because the implementation of the expectant signature word is formed in an interconnect layer between first and second conductive layers, the expectant signature word is formed in a smaller area of the die.

A signature circuit of the structure presented in the above embodiments provides the advantages of reduced manufacturing test time. Specifically, the expectant signature word is available to the compare circuit without requiring an additional read cycle to obtain the signature word from the associated ROM.

A signature circuit of the structure presented in the above embodiments provides the advantage of single contact or via-opening programmability of both the expectant signature word and the actual programmed data of the ROM.

A signature circuit of the structure presented in the above embodiments provides the attributes of a standard cell. Accordingly, the signature circuit is structurally independent of the associated ROM. Therefore, the signature circuit provides the advantage of utilizing advanced timing driven placement algorithms within the design CAD environment for further improvement in die size. Moreover, a signature circuit structured as a standard cell provides the advantage of improved area utilization because the problem of channel routing is reduced.

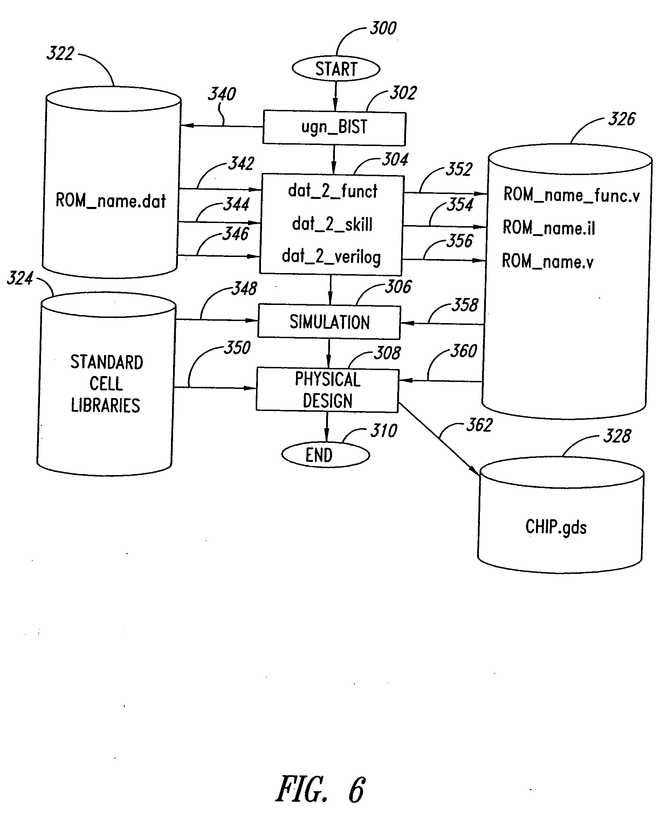

As can be seen in Figure 6, the signature layout structure is created by inputting the signature interconnect data file into the CAD environment at the start 300 and ending at step 310. The resulting signature layout structure that is stored on the chip contains the interconnects, contacts or construction file in memory 328 via-openings, positioned in an arrangement to represent the expectant signature word of the associated read-only memory.

Figure 6 illustrates one acceptable method for implementation for creating the ROM test circuit having a BIST circuit 126, a compare circuit 128 and a signature circuit 124. The steps include providing a ROM data code, a ROM size, and a ROM name which are shown stored on memory 322 to a BIST generator algorithm 302. The BIST generator algorithm 302 creates a ROM signature data file which is transferred to block 304. The ROM signature data file is then provided to a first translation algorithm to create an HDL behavior level simulation model in either VHDL or Verilog of the signature circuit as shown by blocks 304 and 306 together. Next, the ROM signature data file is provided to a second translation algorithm that generates a physical design of a signature interconnect data file as shown in block 308. The signature interconnect data file represents the position coordinates of the contact or via-opening within the interconnect circuit. The ROM signature data file is provided to a translation algorithm that generates a gate-level HDL model in either Verilog or VHDL for the physical layout. Each of the translation algorithms are stored on the mass storage device such as memories 326 and 324 in a partition composed of a library of scripts. The HDL models are stored on the mass storage device 324 in a partition composed of libraries of standard cell models, memory macrocell models and custom cell models.

The method of operation of the test circuit is as follows. First and second supplies are connected to energize the integrated circuit product. For example, a VDD of 1.8 volts and GND of zero volts are connected to the integrated circuit thus energizing the signature circuit of the ROM test circuit. As the supply voltages reach steady state conditions, the output pins of the output circuit swing to a predetermined logic state. The predetermined logic states being defined by a BIST generator algorithm of the CAD environment. The predetermined logic state is a condition of the unique selection of the interconnects of the interconnect circuit. The unique selection of the interconnects is associated with the unique programmed data of the core array of the associated ROM.

The BIST circuit provides address and control data to the associated ROM and receives programmed data words. The BIST circuit operates a signature analysis algorithm on the received programmed data words of the associated ROM to generate a resultant signature word. The resultant signature word is representative of the actual programmed data of the associated ROM.

If the actual programmed data of the associated ROM contained an error where the error is a difference between the actual programmed data and expected programmed data, then the resultant signature word would contain a fault.

A comparison of the resultant signature word to the expectant signature word by a compare circuit provides a verification status to indicate whether the resultant signature word and the expectant signature word matched. This will show if the actual programmed data of the associated ROM matched the expected programmed data. If there was no-match and the actual programmed data does not match the expected programmed data, this is also indicated.

An advantage of the method of the present invention is that there is no additional read cycle to obtain the expectant signature word. Furthermore, the memory status is available at the combinational logic speed of the compare process upon the presentation of the resultant signature word.

An embodiment of the compare circuit comprises a first stage of exclusive-OR logic cells, each XOR cell receives a bit of the expectant and resultant signature words. Specifically, the first XOR cell receives the least significant bit of the expectant signature word and the resultant signature word. Successive XOR cells are connected in a like manner until the final XOR receives the most significant bits of the expectant signature word and the resultant signature word. A second stage XOR cell input pins receive the outputs of the first stage of XOR cells. The second stage XOR cell provides a verification status of the ROM at an output pin. The output pin of the second stage XOR cell is connected to a first input pin of a multiplexer having a second input pin connected to the second supply (GND). The multiplexer is controlled by an enable pin, which is connected to test control logic. The test control logic allows the multiplexer to be disabled by setting the output state to ground (GND), during normal mode operation of the integrated circuit. The output pin of the multiplexer is connected to an input pin of an I/O pad cell. The I/O pad cell provides a connection to the external test equipment.

An embodiment of the reference signature circuit comprises an output circuit and an interconnect circuit. The interconnect circuit is structured to contain a set of interconnects, either contacts or via-openings, to connect an input of the output circuit to either VDD or GND. The selection of either VDD or GND for an interconnect is described as the signature programming data. The signature programming data is representative of the bits of the expectant signature word. The signature programming data is uniquely associated with the expected programming data of the associated ROM circuit. The output circuit is structured to contain a set of buffer circuits. Each buffer circuit is coupled to an interconnect such that the output of each buffer circuit is driven to a logic hi or low to represent the expectant signature word logic value.

An embodiment of the signature circuit layout comprises a buffer circuit layout and an interconnect circuit layout. The interconnect circuit layout comprises a first set of parallel conductive strips formed in a first conductive layer, an interconnect structure and second set of parallel conductive strips formed in a second conductive layer. The first set of parallel conductive strips is formed in eight pairs. A first strip of the pair is connected to a first supply and a second strip of the pair is connected to a second supply. The first set of parallel conductive strips is spaced apart by the minimum design spacing distance allowed by the process for the first conductive layer. The second set of parallel conductive strips is formed in a second conductive layer. The second set of parallel conductive strips are positioned orthogonal to the first set of parallel conductive strips thereby creating overlapping regions of the first and second conductive layers. Each strip of the second set is connected to an input pin of an output buffer. The second set of parallel conductive strips is spaced apart by the minimum design spacing distance allowed by the process for the second conductive layer. A first pair of power strips (VDD, GND) is formed in the second conductive material and positioned to overlap first end-points of each corresponding strip of the first set of parallel strips. A second pair of power strips (VDD, GND) is formed in the second conductive material and positioned to overlap second end-points of each corresponding strip of the first set of parallel strips. The interconnect circuit layout comprises an insulation layer formed of a dielectric material and structured to electrically isolate the first and second conductive layers. The interconnect circuit layout includes contacts or via-openings structured to electrically connect the first and second set of parallel conductive strips at the overlapping regions, and first and second pair of power strips.

An advantage of the present invention is that the signature circuit is structured to reduce the semiconductor area required for an expectant signature word.

An advantage of the present invention is that the signature circuit is structured to provide improved manufacturing test time by providing an expectant signature word without need of a read cycle.

An advantage of the present invention is that the signature circuit is structured to be capable of placement within a standard cell area and be compatible with advanced CAD placement algorithms.

An embodiment of the present invention provides for a method for implementation of a BIST circuit having a signature circuit. The BIST algorithm can be stored on a computer aided design environment, CAD. The CAD environment permits the circuits to be easily designed and constructed on the ROM 10.

An advantage of the method of implementation of a BIST circuit is that the resulting signature circuit layout is structurally independent of the associated ROM. Accordingly, the signature circuit layout can be placed in a location within a standard cell region. The improved placement of the signature circuit layout allows for more efficient utilization of the semiconductor area.

An advantage of the method of implementation of a BIST circuit is that the resulting signature circuit layout includes two separate layout structures, the interconnect layout and the output layout. Accordingly, the integrated circuit design time is reduced; and also, the time required to revise ROM data code is reduced.

An advantage of the method of implementation of a BIST circuit is that the resulting BIST circuit, associated ROM and signature circuit are each independently verifiable within the CAD environment. Accordingly, integrated circuit reliability improved.

All of the above U.S. patents, U.S. patent application publications, U.S. patent applications, foreign patents, foreign patent applications and non-patent publications referred to in this specification and/or listed in the Application Data Sheet, are incorporated herein by reference, in their entirety.

From the foregoing it will be appreciated that, although specific embodiments of the invention have been described herein for purposes of illustration, various modifications may be made without deviating from the spirit and scope of the invention. Accordingly, the invention is not limited except as by the appended claims.

## Claims

1. A circuit comprising:
a built-in-self-test circuit having an address output, a data output and an resultant signature output;
a memory circuit having an address input and a data output coupled to the address output and the data input of the built-in-self-test circuit, respectively, and having a programmed state;
a compare circuit having resultant signature input coupled to the resultant signature output of the built-in-self-test circuit, an expected signature input and a status output; and
a signature circuit having an expectant signature output coupled to the expected signature input of the compare circuit such that an indication of validity of the programmed state of the memory is present on the status output of the compare circuit.

2. The circuit of claim 1, wherein the signature circuit further comprises a first plurality of conductive straps, a second plurality of conductive straps and a plurality of contacts such that the plurality of contacts have an arrangement uniquely associated to the expected signature.

3. The circuit of claim 2, wherein each strap of the first plurality of conductive straps is alternately coupled to a first reference voltage and a second reference voltage.

4. The circuit of claim 2 or 3, wherein the first plurality of conductive straps is metal.

5. The circuit of claim 2, 3 or 4, wherein the second plurality of conductive straps is polysilicon.

6. The circuit of any preceding claim, wherein the expected signature is uniquely associated to a simulated programmed state of the memory circuit or a manufactured programmed state of the memory circuit.

7. The circuit of any preceding claim, wherein the expected signature is a plurality of bits, the plurality of bits having a number of bits equal to a integer power of two.

8. A circuit comprising:
a read-only memory circuit having a programmed state;
a signature circuit having a plurality of first conductive paths, a plurality of second conductive paths, and a plurality of contacts, each contact coupled between a first conductive path and a second conductive path, the plurality of contacts having a unique arrangement such that the programmed code of the read-only memory is verifiable.

9. A test circuit comprising:
a read-only memory for storing a predetermined programmed code, the predetermined program code determining a plurality of data words, each data word of the plurality of data words is available at an output of the memory in response to an address word presented at an input of the memory;
a built-in-self-test circuit for calculating a resultant signature word in response to the plurality of data words received from the output of the memory;
a plurality of first conductive paths for receiving a constant logic state;
a plurality of second conductive paths for distributing the constant logic state, the plurality of second conductive paths structured such that a first path of the second conductive paths is coupled to a first reference voltage and a second path of the second conductive paths is coupled to a second reference voltage;
a plurality of contacts for coupling the plurality of first conductive paths to the plurality of second conductive paths, each contact coupled between a path of the plurality of first conductive paths and a path of the plurality of second conductive paths, the plurality of contacts having a unique distribution to store an expected signature word; and
a compare circuit for receiving the resultant signature word from the built-in-self-test circuit and for determining an equality condition between the resultant signature word and the expected signature word thus validating the predetermined programmed code of the read-only memory.

10. The circuit according to claim 9, wherein the first reference voltage defines the constant logic state to be a logical one and the second reference voltage defines the constant logic state to be a logical zero.

11. The circuit according to claim 9 or 10, wherein the unique distribution of the plurality of contacts and the predetermined programmed code of the memory is configured from a single manufacturing mask.

12. The circuit according to claim 9, 10 or 11, wherein the expected signature word is representative of the predetermined.

13. A device comprising:
A ROM circuit having an address input coupled to an address bus, a data output coupled to a data bus wherein the ROM is structure to have a unique programming code;
A BIST circuit having an input coupled to data output of the ROM circuit and an output:
A compare circuit having a first input coupled to the output of the BIST circuit, an output and a second input; and
A signature circuit having an output coupled to the second input of the compare circuit wherein the signature circuit is structure to store a signature word having a unique association to the unique programming code of the ROM circuit.

14. A method of manufacturing a signature cell comprising:
forming a first plurality of conductive paths such that a first conductive path of the first plurality is coupled to a first supply and a second conductive path of the first plurality is coupled to a second supply;
forming a contact at a location on the first conductive path of the first plurality of conductive paths; and
forming a second plurality of conductive paths such that a conductive path of the second plurality of conductive paths is coupled to the first conductive path of the first plurality of conductive paths at the location of the contact.

15. A method of manufacturing a memory signature cell comprising:
forming a first plurality of conductive paths such that a first conductive path of the first plurality is coupled to a first supply and a second conductive path of the first plurality is coupled to a second supply;
forming a contact at a location on the first conductive path of the first plurality of conductive paths; and
forming a second plurality of conductive paths such that a conductive path of the second plurality of conductive paths is coupled to the first conductive path of the first plurality of conductive paths at the location of the contact while simultaneously programming a core memory of a read-only-memory.

16. A method of validating a memory device, comprising:
providing a plurality of address vectors to a memory device;
generating a plurality of data vectors in response to the plurality of address vectors;
generating an resultant signature from the plurality of data vectors, the resultant signature being representative of a current programmed state of the memory device; and
comparing a predetermined signature to the resultant signature such that a status of the programmed state of the memory device is indicated.

17. The method of claim 16, wherein the step of generating a plurality of data vectors includes generating the predetermined signature such that the predetermined signature is representative of an expected programmed state of the memory device.

18. The method of claim 16 or 17, wherein the status is a pass/fail indication of the programmed state of the memory device.

19. The method of any of claims 16 to 18, wherein if the status is a logic 0 then the resultant signature is equivalent to the expected signature, alternatively if the status is a logic 1 then the resultant signature is not equivalent to the expected signature.

20. The method of any of claims 16 to 19, wherein the predetermined signature and the resultant signature are bit vectors.
